# FASCICULE DE BREVET EUROPEEN

(11) **EP 2 064 034 B1**
(45) Date de publication et mention de la délivrance du brevet: **24.02.2010**
(21) Numéro de dépôt: 07848220.5
(22) Date de dépôt: 13.09.2007
(51) Int. Cl.: B25J 9/16

(54) **STATION DE TRAVAIL AVEC SUPPORT DE PIECES MULTIFACE ET PROCEDE DE PILOTAGE D'UNE TELLE STATION**
ARBEITSSTATION MIT POLYGONALEM TEILEHALTER UND STEUERUNGSVERFAHREN FÜR EINE SOLCHE STATION
WORKSTATION WITH MULTIFACE PARTS HOLDER AND CONTROL METHOD FOR SUCH A STATION

(30) Priorité: 14.09.2006 FR 0608033
(43) Date de publication de la demande: 03.06.2009
(73) Titulaire: ABB France, 92566 Rueil Malmaison (FR)
(72) Inventeur: DEMIT, Daniel, 92400 Courbevoie (FR); LEGELEUX, Fabrice, 95630 Meriel (FR); MALATIER, François, 95150 Taverny (FR)
(74) Mandataire: Lavialle, Bruno François Stéphane
(86) Numéro de dépôt international: PCT/FR2007/001479
(87) Numéro de publication internationale: WO 2008/031945

(56) Documents cités:
- DE-A1-102004 021 389
- US-A- 5 479 698

## Description

La présente invention concerne une station de travail et un procédé de pilotage d'une telle station de travail. Une station de travail de ce type est utilisable par exemple pour la fabrication de pièces de carrosserie de véhicules automobiles. Le document US 5 479 698 A décrit une telle station de travail, selon le préambule de la revendication 1 et un tel procédé selon le préambule de la revendication 13.

### ARRIERE PLAN DE L'INVENTION

Une station de travail comporte généralement un bâti sur lequel sont fixés au minimum un robot manipulateur de pièces et une unité opérationnelle destinée à réaliser au moins une opération sur les pièces, comme une opération d'assemblage, de soudage, de sertissage ou autre. Le robot manipulateur est en général piloté pour charger les pièces sur un support solidaire du bâti et agencé pour maintenir la pièce dans une position prédéterminée de manière à servir de référence géométrique pour l'opération réalisée par l'unité opérationnelle. Une fois l'opération terminée, le robot manipulateur saisit la pièce pour la déposer à l'extérieur de la station de travail.

Les utilisateurs de telles stations de travail ont généralement un besoin de rentabilité, c'est-à-dire d'exploiter au maximum les stations de travail et les éléments qui les composent, et de flexibilité de manière que les stations de travail puissent être facilement adaptées à différents types de pièces, différentes cadences et à des modification du processus de fabrication, ce besoin de flexibilité ne devant toutefois pas être satisfait au détriment de la rentabilité. En outre, il apparaît nécessaire de rendre les stations de travail de plus en plus compactes afin d'exploiter au mieux la surface disponible sans pour autant sacrifier leur flexibilité.

### OBJET DE L'INVENTION

Un but de l'invention est de proposer une station de travail permettant de satisfaire au moins en partie les besoins ci-dessus énoncés.

### RESUME DE L'INVENTION

A cet effet, on prévoit, selon l'invention, une station de travail robotisée, comportant au moins un robot multiaxe manipulateur de pièces ayant un bras avec une extrémité libre pourvue d'un support de pièces, une première unité opérationnelle et une deuxième unité opérationnelle pour coopérer fonctionnellement avec le support, le support comportant un corps pourvu d'emplacements de réception de pièces disposés pour être simultanément accessibles chacun par une des unités opérationnelles.

Ainsi, le positionnement des pièces dans la station est assuré par le robot manipulateur et les unités opérationnelles peuvent opérer simultanément sur le support positionné par le robot manipulateur. Il est alors possible d'effectuer des opérations en temps masqué et de compenser des variations dimensionnelles entre des séries de pièces en modifiant la position et l'inclinaison du support dans la station.

De préférence, le corps du support comprend plusieurs faces définissant chacune un emplacement de réception de pièces et, avantageusement, les emplacements sont agencés sur deux faces opposées du corps, le corps étant monté sur l'extrémité libre du bras du robot manipulateur pour pivoter autour d'un axe s'étendant symétriquement par rapport aux faces.

Ce mode réalisation est particulièrement avantageux puisqu'il limite les risques d'interférences entre les unités opérationnelles coopérant simultanément avec le support.

De préférence encore, la station comprend au moins autant d'unités opérationnelles susceptibles de coopérer fonctionnellement avec le support que le corps du support compte de faces pourvues d'emplacement de réception de pièce.

Ceci permet d'exploiter pleinement les possibilités offertes par l'agencement de plusieurs emplacements de pièces sur le support.

Avantageusement, une des unités opérationnelles est agencée pour coopérer opérationnellement avec plusieurs faces du support successivement.

L'invention a également pour objet, un procédé de pilotage d'une station de travail comportant au moins un robot manipulateur ayant un bras avec une extrémité libre pourvue d'un support pourvu d'au moins un premier et un deuxième emplacements de réception de pièce, une première unité opérationnelle sous la forme d'un robot de chargement de pièce dans les emplacements, et une deuxième unité opérationnelle, les emplacements étant disposés pour être accessibles simultanément chacun par le robot de chargement et la deuxième unité opérationnelle, le procédé comprenant les étapes de :
- commander le robot de chargement pour charger une pièce dans le premier emplacement,
- commander le robot manipulateur pour qu'il présente la pièce reçue dans le premier emplacement à la deuxième unité opérationnelle,
- commander la deuxième unité opérationnelle pour qu'elle réalise une opération sur la pièce ainsi présentée et commander le robot de chargement pour qu'il charge une pièce dans le deuxième emplacement pendant l'opération réalisée par la deuxième unité opérationnelle.

Le chargement de la pièce est ainsi réalisé en temps masqué.

D'autres caractéristiques et avantages de l'invention ressortiront à la lecture de la description qui suit de modes de réalisation particuliers non limitatifs de l'invention.

### BREVE DESCRIPTION DES DESSINS

Il sera fait référence aux dessins annexés, parmi lesquels :
- la figure 1 est une vue schématique en élévation d'une station de travail conforme à un premier mode de réalisation de l'invention,
- la figure 2 est une vue schématique partielle d'une station de travail conforme à un deuxième mode de réalisation de l'invention.

### DESCRIPTION DETAILLEE DE L'INVENTION

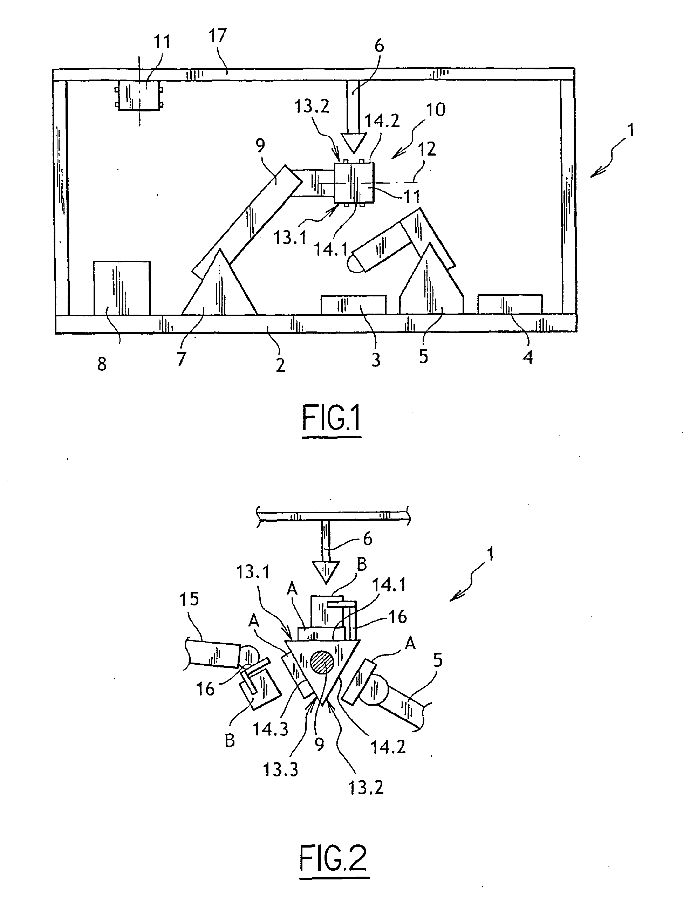

En référence à la figure 1, la station de travail conforme au premier mode de réalisation est destinée à assurer le soudage final d'une pièce comportant deux parties pré-assemblées.

La station de travail, généralement désignée en 1, comporte un bâti 2 sur lequel sont montés un convoyeur 3 d'amenée de pièces, un convoyeur 4 d'évacuation des pièces, une première unité opérationnelle 5, une deuxième unité opérationnelle 6 et un robot manipulateur 7 multiaxe. Les convoyeurs 3, 4, les unités opérationnelles 5, 6 et le robot manipulateur 7 sont reliés à une unité de pilotage 8 comportant un système informatique exécutant un programme agencé pour faire fonctionner de façon coordonnée les éléments précités constituant la station de travail 1.

Le bâti 2 comprend de façon connue en elle-même une semelle qui repose sur le sol et qui est surmontée d'une armature et entourée par une ceinture de protection non visible sur la figure 1 (grilles, enveloppe...). La semelle permet de fixer la station de travail 1 au sol et comprend des passages pour les câbles électriques d'alimentation et de commande des composants de la station de travail 1. La semelle peut en outre être agencée pour former une partie d'une ligne modulaire de production par exemple en incorporant des moyens de sa liaison fonctionnelle par rapport à une station de travail adjacente. Les moyens de liaison fonctionnelle comportent par exemple des moyens de liaison mécanique des stations entre elles, des moyens d'interconnexion des câbles d'alimentation et/ou de commande des stations de travail...

Les convoyeurs 3 et 4 sont constitués chacun d'une ligne de transport sans fin montée sur le bâti 2 de telle manière que chaque convoyeur 3, 4 ait une extrémité au voisinage de la première unité opérationnelle 5 et une extrémité opposé au voisinage d'un bord de la station de travail 1. Hors de la station, les pièces sont chargées sur le convoyeur 3 d'amenée et déchargées du convoyeur 4 d'évacuation par exemple par un opérateur ou un robot.

La première unité opérationnelle 5 est formée d'un robot de chargement/déchargement piloté pour saisir les pièces à travailler sur le convoyeur 3 et pour déposer les pièces travaillées sur le convoyeur 4.

La deuxième unité opérationnelle 6 est ici une tête de soudage laser montée sur l'armature du bâti 2 sensiblement au-dessus du robot de chargement/déchargement 5. La tête de soudage 6 possède un débattement angulaire et est déplaçable angulairement selon ce débattement.

Le robot manipulateur 7 comprend un bras 9 ayant une extrémité reliée à la semelle du bâti 2 et une extrémité opposée libre pourvue d'un support 10 de pièces. Le support 10 comprend un corps 11, ici en forme de tambour, qui est monté sur l'extrémité libre du bras 9 pour pivoter autour d'un axe 12 et qui possède deux faces 13.1, 13.2 opposées l'une à l'autre et parallèles à l'axe 12. Sur chaque face 13.1, 13.2 sont fixés des organes de maintien et de positionnement d'une pièce de manière à définir un emplacement 14.1, 14.2 pour une pièce.

En fonctionnement, des pièces étant présentes sur le convoyeur 3, le robot manipulateur 7 est commandé pour disposer le support 10 au voisinage du robot de chargement/déchargement 5 et de la tête de soudage 6 de manière que les emplacements 14.1, 14.2 soient accessibles chacun par le robot de chargement/déchargement 5 et la tête de soudage 6.

L'unité de pilotage 8 commande le robot de chargement/déchargement 5 pour qu'il saisisse une pièce sur le convoyeur 3 et la positionne dans l'emplacement 14.1 que lui présente le robot manipulateur 7. Le robot manipulateur 7 bloque la pièce et fait ensuite pivoter le support 10 pour présenter la pièce à la tête de soudage 6 et l'emplacement 14.2 au robot de chargement/déchargement 5.

La tête de soudage 6 commence alors l'opération de soudage et le robot manipulateur 7 déplace le support 10 et la pièce pour que le faisceau laser atteigne les parties à souder.

Pendant l'opération de soudage, l'unité de pilotage 8 commande le robot de chargement/déchargement 5 pour qu'il saisisse une pièce sur le convoyeur 3 et la positionne dans l'emplacement 14.2 que lui présente le robot manipulateur 7. Comme le robot manipulateur 7 déplace le support 10 pour le soudage, le robot de chargement/déchargement 5 est commandé en coordination avec le robot manipulateur 7 pour charger la pièce dans l'emplacement 14.2 en suivant les mouvements du support 10.

A la fin du soudage, l'unité de pilotage 8 commande le pivotement du support 10 pour amener l'emplacement 14.2 devant la tête de soudage 6 et l'emplacement 14.1 devant le robot de chargement/déchargement 5.

La tête de soudage 6 commence alors l'opération de soudage et le robot manipulateur 7 déplace le support 10 et la pièce pour que le faisceau laser atteigne les parties à souder.

Pendant l'opération de soudage, l'unité de pilotage 8 commande le robot de chargement/déchargement 5 pour qu'il saisisse la pièce dans l'emplacement 14.1 que lui présente le robot manipulateur 7 et la dépose sur le convoyeur 4, et pour qu'il saisisse une pièce sur le convoyeur 3 et la positionne dans l'emplacement 14.1. Comme le robot manipulateur 7 déplace le support 10 pour le soudage, le robot de chargement/déchargement 5 est commandé en coordination avec le robot manipulateur 7 pour décharger la pièce soudée de l'emplacement 14.1 et pour charger une pièce à souder dans l'emplacement 14.1 en suivant les mouvements du support 10.

Le cycle se poursuit alors comme précédemment.

On notera que la station possède un magasin 17 de supports 11 pouvant recevoir plusieurs supports 11 adaptés à des pièces différentes et le bras 9 du robot manipulateur est agencé pour pouvoir se connecter à un support 11 et s'en déconnecter de manière que le robot manipulateur 7 puisse changer de support 11 en fonction des pièces à assembler.

Les éléments identiques ou analogues à ceux précédemment décrits porteront la même référence numérique dans la description qui suit du deuxième mode de réalisation représentée à la figure 2.

La station de travail 1 du deuxième mode de réalisation est globalement identique à celle du premier mode de réalisation, à savoir qu'elle comporte un robot de chargement/déchargement 5, une tête de soudage 6 et un robot manipulateur 7 dont seul le bras 9 est ici visible (représenté en coupe transversale sur la figure 2).

La station de travail 1 est ici néanmoins agencée pour souder l'une à l'autre une pièce d'un premier type A et une pièce d'un deuxième type B amenées séparément dans la station de travail 1 par des moyens de transport connus en eux-mêmes tels que des convoyeurs ou des robots.

Le robot de chargement/déchargement 5 est piloté pour charger les pièces du premier type A sur le support 10 et pour décharger du support 10 l'ensemble soudé formé par l'assemblage d'une pièce du premier type A et d'une pièce du deuxième type B.

La station de travail 1 comprend un robot de chargement 15 supplémentaire piloté pour charger sur le support 10 les pièces du deuxième type solidaires de châssis de maintien additionnels ou supports intermédiaires 16.

Le support 10 comporte trois faces 13.1, 13.2, 13.3 sur lesquelles sont agencées des emplacements 14.1, 14.2, 14.3 de réception de pièces, ces emplacements comprenant des moyens de maintien et de positionnement des pièces du premier type A et des moyens de maintien et de positionnement des supports intermédiaires 16.

En fonctionnement, le robot manipulateur 7 est commandé pour disposer le support 10 au voisinage du robot de chargement/déchargement 5, du robot de chargement 15 et de la tête de soudage 6 de manière que les emplacements 14.1, 14.2, 14.3 soient accessibles chacun par le robot de chargement/déchargement 5, le robot de chargement 15 et la tête de soudage 6.

Au début du cycle, l'unité de pilotage 8 commande le robot de chargement/déchargement 5 pour qu'il saisisse une pièce du premier type A et la positionne dans l'emplacement 14.1 que lui présente le robot manipulateur 7. Le robot manipulateur 7 bloque la pièce et fait ensuite pivoter le support 10 pour présenter l'emplacement 14.1 au robot de chargement 15, l'emplacement 14.2 à la tête de soudage 6 et l'emplacement 14.3 au robot de chargement/déchargement, 5.

L'unité de pilotage 8 commande le robot de chargement/déchargement 5 pour qu'il saisisse une pièce du premier type A et la positionne dans l'emplacement 14.3 que lui présente le robot manipulateur 7 et commande le robot de chargement 15 pour qu'il saisisse une pièce du deuxième type B et son support intermédiaire 16 et les positionne dans l'emplacement 14.1 que lui présente le robot manipulateur 7. Le robot manipulateur 7 bloque la pièce du premier type A dans l'emplacement 14.3 et le support intermédiaire 16 dans l'emplacement 14.1 et fait ensuite pivoter le support 10 pour présenter l'emplacement 14.3 au robot de chargement 15, l'emplacement 14.1 à la tête de soudage 6 et l'emplacement 14.2 au robot de chargement/déchargement 5.

La tête de soudage 6 commence alors l'opération de soudage des pièces reçues dans l'emplacement 14.1 et le robot manipulateur 7 déplace le support 10 et les pièces pour que le faisceau laser atteigne les pièces à souder.

Pendant l'opération de soudage, l'unité de pilotage 8 commande le robot de chargement/déchargement 5 pour qu'il saisisse une pièce du premier type A et la positionne dans l'emplacement 14.2 que lui présente le robot manipulateur 7 et commande le robot de chargement 15 pour qu'il saisisse une pièce du deuxième type B et son support intermédiaire 16 et les positionne dans l'emplacement 14.3 que lui présente le robot manipulateur 7. Comme le robot manipulateur 7 déplace le support 10 pour le soudage, le robot de chargement/déchargement 5 et le robot de chargement 15 sont commandés en coordination avec le robot manipulateur 7 pour charger les pièces dans les emplacements 14.2, 14.3 en suivant les mouvements du support 10. Le robot manipulateur 7 bloque les pièces et le support intermédiaire 16 assurant la mise en géométrie des pièces.

A la fin de l'opération de soudage, le robot manipulateur 7 fait pivoter le support 10 pour présenter l'emplacement 14.2 au robot de chargement 15, l'emplacement 14.3 à la tête de soudage 6 et l'emplacement 14.1 au robot de chargement/déchargement 5.

La tête de soudage 6 commence alors l'opération de soudage des pièces reçues dans l'emplacement 14.3 et le robot manipulateur 7 déplace le support 10 et les pièces pour que le faisceau laser atteigne les pièces à souder.

Pendant l'opération de soudage, l'unité de pilotage 8 commande le robot de chargement/déchargement 5 pour qu'il saisisse l'ensemble soudé dans l'emplacement 14.1 que lui présente le robot manipulateur 7, le dépose sur les moyens de transport, saisisse une pièce du premier type et la positionne dans l'emplacement 14.1. Simultanément, l'unité de pilotage 8 commande le robot de chargement 15 pour qu'il saisisse une pièce du deuxième type et son support intermédiaire 16 et les positionne dans l'emplacement 14.2 que lui présente le robot manipulateur 7. Comme le robot manipulateur 7 déplace le support 10 pour le soudage, le robot de chargement/déchargement 5 et le robot de chargement 15 sont commandés en coordination avec le robot manipulateur 7 pour suivre les mouvements du support 10 en effectuant leurs opérations de chargement et déchargement. Le robot manipulateur 7 bloque les pièces et le support intermédiaire.

A la fin de l'opération de soudage, le robot manipulateur 7 fait ensuite pivoter le support 10 pour présenter l'emplacement 14.1 au robot de chargement 15, l'emplacement 14.2 à la tête de soudage 6 et l'emplacement 14.3 au robot de chargement/déchargement 5.

Le cycle se poursuit alors comme précédemment.

Bien entendu, l'invention n'est pas limitée aux modes de réalisation décrits mais englobe toute variante de réalisation entrant dans le cadre de l'invention tel que défini par les revendications.

En particulier, on peut prévoir que le robot manipulateur mette le support 10 en appui contre des plots de référence solidaires du bâti 2 de la station de travail 1 lors des opérations réalisées par les autres robots (dans l'hypothèse où il n'est pas nécessaire de déplacer le support lors de la réalisation des opérations).

La fonction des convoyeurs 3, 4 peut être assuré par le robot de chargement/déchargement 5 ou par d'autres robots.

Les unités opérationnelles peuvent être des têtes de travail (soudage, collage, meulage, rivetage...), fixes ou mobiles, ou des robots de travail. Ainsi, la tête de soudage 6 peut être fixe ou mobile.

En variante du deuxième mode de réalisation, le support peut avoir quatre faces et la station de travail peut comporter soit une deuxième unité opérationnelle de travail soit un robot de déchargement de l'ensemble soudé du support 10, le robot 5 n'assurant alors que le chargement des pièces du premier type sur le support 10.

En variante, il est possible de ne pas utiliser un robot 15, le robot 5 assurant alors le déchargement des pièces assemblées A + B et du support 16, le chargement de la pièce 1 puis le chargement de la pièce B et du support 16.

L'axe 12 peut s'étendre symétriquement par rapport aux faces 13.1, 13.2 sans être parallèle à celles-ci, par exemple lorsque le support a une forme pyramidale, notamment en tétraèdre.

## Revendications

1. Station de travail (1) robotisée comportant au moins un robot multiaxe manipulateur (7) de pièces ayant un bras (9) avec une extrémité libre pourvue d'un support (10) de pièces, une première unité opérationnelle (5) et une deuxième unité opérationnelle (6) pour coopérer fonctionnellement avec le support, le support comportant un corps (11) pourvu d'emplacements (14) de réception de pièce **caractérisée en ce que** les emplacements sont disposés pour être simultanément accessibles chacun par une des unités opérationnelles.

2. Station selon la revendication 1, dans laquelle le corps (11) du support (10) comprend plusieurs faces (13) définissant chacune un emplacement (14) de réception de pièces.

3. Station selon la revendication 2, dans laquelle les emplacements (14) sont agencés sur deux faces (13) opposées du corps (11), le corps étant monté sur l'extrémité libre du bras (9) du robot manipulateur (7) pour pivoter autour d'un axe (12) s'étendant symétriquement par rapport aux faces.

4. Station selon la revendication 2, comprenant au moins autant d'unités opérationnelles (5, 6, 15) susceptibles de coopérer fonctionnellement avec le support (10) que le corps (11) du support (10) compte de faces (13) pourvues d'emplacements (14) de réception de pièce.

5. Station selon la revendication 1, dans laquelle le robot manipulateur (7) comprend un changeur de support.

6. Station selon la revendication 5, dans laquelle au moins une des unités opérationnelles (5, 6) est agencée pour coopérer opérationnellement avec au moins deux faces du support (11) successivement.

7. Station selon la revendication 1, dans laquelle les emplacements (14) sont pourvus de moyens de mise en géométrie des pièces.

8. Station selon la revendication 1, dans laquelle au moins un des emplacements (14) est pourvu de moyens de retenue d'un châssis de maintien additionnel (16) d'une pièce à assembler à une pièce positionnée dans l'emplacement.

9. Station selon la revendication 1, dans laquelle la première unité opérationnelle est un robot de chargement (5) de pièces sur le support (10).

10. Station selon la revendication 1, dans laquelle la première unité opérationnelle est un robot de déchargement (5) de pièces du le support (10).

11. Station selon la revendication 1, dans laquelle la deuxième unité opérationnelle est une tête de travail (6) sensiblement fixe, la station comportant une unité de pilotage (8) agencée pour coordonner des mouvements du robot manipulateur (7) et de la première unité opérationnelle (5).

12. Station selon la revendication 11, dans laquelle le robot manipulateur (7, 5) et au moins une des unités opérationnelles sont reliés à une même unité de pilotage (8).

13. Procédé de pilotage d'une station de travail comportant au moins un robot manipulateur (7) ayant un bras (9) avec une extrémité libre pourvue d'un support (10) pourvu d'au moins un premier et un deuxième emplacements (14.1, 14.2) de réception de pièce, une première unité opérationnelle et une deuxième unité opérationnelle (6), **caractérisé en ce que** la première unité opérationnelle est un robot de chargement (5) de pièce dans les emplacements, les emplacements étant disposés pour être accessibles simultanément chacun par le robot de chargement et la deuxième unité opérationnelle, et **en ce que** le procédé comprend les étapes de :
- commander le robot de chargement pour charger une pièce dans le premier emplacement,
- commander le robot manipulateur pour qu'il présente la pièce reçue dans le premier emplacement à la deuxième unité opérationnelle,
- commander la deuxième unité opérationnelle pour qu'elle réalise une opération sur la pièce ainsi présentée et commander le robot de chargement pour qu'il charge une pièce dans le deuxième emplacement pendant l'opération réalisée par le deuxième unité opérationnelle.

14. Procédé selon la revendication précédente, dans lequel, lors de l'opération, le robot manipulateur (7) déplace le support (10) et le robot de chargement (5) est commandé en coordination avec le robot manipulateur pour charger la pièce dans le deuxième emplacement.

## Claims

1. A robotic workstation (1) comprising at least one multiple-axis parts-handling robot (7) having an arm (9) with a free end that is provided with a parts support (10), and first and second operational units (5, 6) for co-operating functionally with the support, the support comprising a body (11) provided with locations (14) for receiving parts, **characterized in that** said locations are arranged so that each of them is accessible simultaneously by one of the operational units.

2. A workstation according to claim 1, wherein the body (11) of the support (10) has a plurality of faces (13), each defining a location (14) for receiving parts.

3. A workstation according to claim 2, wherein the locations (14) are arranged on two opposite faces (13) of the body (11), the body being mounted on the free end of the arm (9) of the handling robot (7) to pivot about an axis (12) extending symmetrically relative to the faces.

4. A workstation according to claim 2, including at least as many operational units (5, 6, 15) suitable for co-operating functionally with the support (10) as the body (11) of the support (10) has faces (13) provided with locations (14) for receiving parts.

5. A workstation according to claim 1, wherein the handling robot (7) includes a support changer.

6. A workstation according to claim 5, wherein as least one of the operational units (5, 6) is arranged to cooperate operationally with at least two faces of the support (11) in succession.

7. A workstation according to claim 1, wherein the locations (14) are provided with means for geometrically positioning parts.

8. A workstation according to claim 1, wherein at least one of the locations (14) is provided with means for retaining an optional holding frame (16) for holding a part for assembling to a part that is positioned in the location.

9. A workstation according to claim 1, wherein the first operational unit is a loading robot (5) for loading parts on the support (10).

10. A workstation according to claim 1, wherein the first operational unit is an unloading robot (5) for unloading parts from the support (10).

11. A workstation according to claim 1, wherein the second operational unit is a substantially stationary work head (6), the station including a control unit (8) arranged to coordinate movements of the handling robot (7) and of the first operational unit (5).

12. A workstation according to claim 11, wherein the handling robot (7, 5) and at least one of the operational units are connected to a common control unit (8).

13. A method of controlling a workstation comprising at least one handling robot (7) having an arm (9) with a free end provided with a support (10) provided with at least first and second parts-receiving locations (14.1, 14.2), a first operational unit, and second operational unit (6), **characterized in that** the first operational unit is a loading robot (5) for loading parts into the locations the locations being disposed so that each of them is accessible simultaneously by the loading robot and the operational unit, and **in that** the method comprises the steps of:
· controlling the loading robot to load a part in the first location;
· controlling the handling robot to present the part received in the first location to the second operational unit; and
· controlling the second operational unit to perform an operation on the part as presented thereto and controlling the loading robot to load a part in the second location while the operation is being performed by the second operational unit.

14. A method according to the preceding claim, wherein during the operation, the handling robot (7) moves the support (10) and the loading robot (5) is controlled in coordination with the handling robot to load the part into the second location.

## Patentansprüche

1. Robotergestützte Arbeitsstation (1), umfassend mindestens einen mehrachsigen Teile-Manipulationsroboter (7), der einen Arm (9) mit einem freien Ende hat, das mit einem Teileträger (10) versehen ist, sowie eine erste Funktionseinheit (5) und eine zweite Funktionseinheit (6), die dazu bestimmt sind, funktional mit dem Träger zusammenzuarbeiten, wobei der Träger ein Gehäuse (11) umfasst, das mit Aufnahmeplätzen (14) für Teile versehen ist, **dadurch gekennzeichnet, dass** die Aufnahmeplätze derart angeordnet sind, dass sie jeweils gleichzeitig für eine der Funktionseinheiten zugänglich sind.

2. Station nach Anspruch 1, wobei das Gehäuse (11) des Trägers (10) mehrere Seiten (13) umfasst, die jeweils einen Aufnahmeplatz (14) für Teile festlegen.

3. Station nach Anspruch 2, wobei die Aufnahmeplätze (14) auf zwei gegenüberliegenden Seiten (13) des Gehäuses (11) angeordnet sind, wobei das Gehäuse an dem freien Ende des Arms (9) des Manipulationsroboters (7) gelagert ist, um sich um eine Achse (12) zu drehen, die symmetrisch zu den Seiten verläuft.

4. Station nach Anspruch 2, umfassend mindestens so viele Funktionseinheiten (5, 6, 15), die dazu geeignet sind, funktional mit dem Träger (10) zusammenzuarbeiten, wie das Gehäuse (11) des Trägers (10) Seiten (13) aufweist, die mit Aufnahmeplätzen (14) für Teile versehen sind.

5. Station nach Anspruch 1, wobei der Manipulationsroboter (7) einen Trägerwechsler umfasst.

6. Station nach Anspruch 5, wobei mindestens eine der Funktionseinheiten (5, 6) derart ausgebildet ist, dass sie nacheinander mit mindestens zwei Seiten des Trägers (11) funktionsfähig zusammenwirkt.

7. Station nach Anspruch 1, wobei die Aufnahmeplätze (14) mit Mittel versehen sind, um die Teile auszurichten.

8. Station nach Anspruch 1, wobei mindestens einer der Aufnahmeplätze (14) mit Haltemitteln zum Halten eines zusätzlichen Haltegestells (16) zum Halten eines Teils versehen ist, das an einem in dem Aufnahmeplatz positionierten Teil montiert werden soll.

9. Station nach Anspruch 1, wobei die erste Funktionseinheit ein Laderoboter (5) zum Laden von Teilen auf den Träger (10) ist.

10. Station nach Anspruch 1, wobei die erste Funktionseinheit ein Entladeroboter (5) zum Entladen von Teilen von dem Träger (10) ist.

11. Station nach Anspruch 1, wobei die zweite Funktionseinheit ein im Wesentlichen ortsfester Arbeitskopf (6) ist, wobei die Station eine Steuereinheit (8) umfasst, die derart ausgebildet ist, dass sie die Bewegungen des Manipulationsroboters (7) und der ersten Funktionseinheit (5) koordiniert.

12. Station nach Anspruch 11, wobei der Manipulationsroboter (7, 5) und mindestens eine der Funktionseinheiten an ein und dieselbe Steuereinheit (8) angeschlossen sind.

13. Verfahren zur Steuerung einer Arbeitsstation, die mindestens einen Manipulationsroboter (7) umfasst, der einen Arm (9) mit einem freien Ende hat, das mit einem Träger (10) versehen ist, der mit mindestens einem ersten und einem zweiten Aufnahmeplatz (14.1, 14.2) für Teile versehen ist, sowie eine erste Funktionseinheit und eine zweite Funktionseinheit (6), **dadurch gekennzeichnet, dass** die erste Funktionseinheit ein Laderoboter (5) zum Laden von Teilen in die Aufnahmeplätze ist, wobei die Aufnahmeplätze derart angeordnet sind, dass sie jeweils gleichzeitig für den Laderoboter und die zweite Funktionseinheit zugänglich sind, und dass das Verfahren die Schritte umfasst:
- Steuern des Laderoboters zum Laden eines Teils in den ersten Aufnahmeplatz,
- Steuern des Manipulationsroboters derart, dass er das in dem ersten Aufnahmeplatz aufgenommene Teil der zweiten Funktionseinheit präsentiert,
- Steuern der zweiten Funktionseinheit derart, dass sie eine Operation an dem so präsentierten Teil ausführt, und Steuern des Laderoboters derart, dass er während der von der zweiten Funktionseinheit ausgeführten Operation ein Teil in den zweiten Aufnahmeplatz lädt.

14. Verfahren nach dem vorhergehenden Anspruch, wobei der Manipulationsroboter (7) den Träger (10) während der Operation verschiebt und der Laderoboter (5) in Koordination mit dem Manipulationsroboter gesteuert wird, um das Teil in den zweiten Aufnahmeplatz zu laden.
